# EUROPÄISCHE PATENTSCHRIFT

(11) **EP 0 725 161 B1**
(45) Veröffentlichungstag und Bekanntmachung des Hinweises auf die Patenterteilung: **15.04.1998**
(21) Anmeldenummer: 95119817.5
(22) Anmeldetag: 15.12.1995
(51) Int. Cl.: C23C 14/02, C23C 14/30

(54) **Verfahren zur Plasmabehandlung von Werkstücken**
Method for plasma treating of worked articles
Procédé pour le traitement au plasma de pièces

(30) Priorität: 06.01.1995 DE 19500262
(43) Veröffentlichungstag der Anmeldung: 07.08.1996
(73) Patentinhaber: METAPLAS IONON Oberflächenveredelungstechnik GmbH, D-51427 Bergisch Gladbach (DE)
(72) Erfinder: Vetter, Jörg, Dr., 51469 Bergisch-Gladbach (DE); Maxam, Siegfried, 51766 Engelskirchen (DE); Schmidt-Mauer, Manfred, 51491 Overath (DE)
(74) Vertreter: Stenger, Watzke & Ring Patentanwälte

(56) Entgegenhaltungen:
- EP-A- 0 483 839
- EP-A- 0 484 704
- DD-A- 268 715

## Beschreibung

Die Erfindung betrifft ein Verfahren zur Plasmabehandlung von Werkstücken mittels Ionen und Elektronen, insbesondere vor der Plasmabeschichtung unter Vakuum nach dem PVD-Verfahren, wobei durch abwechselnden Beschuß mit Ionen und Elektronen die Werkstücke gereinigt bzw. aufgeheizt werden.

Ein Verfahren, das die zwei nacheinander erfolgenden Prozeßschritte Heizung der Substrate mittels der Plasmaelektronen und Ionenreinigung der zur Beschichtung vorgesehenen Werkstücke (der sogenannten "Substrate") zum Inhalt hat, ist beispielsweise aus der EP-PS 0 484 704 bekannt. In der Heizphase sind bei diesem bekannten Verfahren die Substrate als Anode der Plasmaquelle geschaltet, wodurch die Plasmaelektronen angezogen werden. Es kann somit keine getrennte Regelung der Parameter der Plasmaerzeugung und der Parameter der Elektronenheizung vorgenommen werden. Darüber hinaus wirkt sich bei dem bekannten Verfahren die strenge Trennung von Substratheizung und Ionenreinigung ungünstig auf die Prozeßzeit aus. Zwar erfolgt während des Ionenreinigens auch ein gewisser Energieeintrag durch die Energie der auftreffenden Ionen, jedoch ist diese Energie in der Regel zur Erwärmung der Substrate nicht ausreichend, sondern wird erst nach der Elektronenheizung zum "Halten" der Temperatur der Substrate (meist im Bereich von 200°C bis 500°C) während der Ionenreinigungsphase ausgenutzt.

Eine zeitlich schnell wechselnde Umschaltung der Prozeßschritte Elektronenheizung und der Ionenreinigung ist bei dem bekannten Verfahren nicht möglich, da die Substrate einmal mit einer eigenen Substratstromquelle negativer Spannung zum Zwecke der Ionenreinigung verbunden werden und ein anderes Mal als Anode der Plasmaquelle zum Zwecke der Elektronenheizung geschaltet werden. Eine schnelle Umpolung hätte Instabilitäten in der Plasmaerzeugung und somit eine schlecht kontrollierbare Prozeßführung zur Folge.

Davon ausgehend liegt der Erfindung die **Aufgabe** zugrunde, ein Verfahren zur Plasmabehandlung von Werkstücken mittels Ionen und Elektronen zu schaffen, dessen Prozeßführung in der Ionenreinigungs- und Aufheizphase der Werkstücke einfach und individuell genau steuerbar sowie energiesparend ist.

Die **Lösung** der Aufgabenstellung ist dadurch gekennzeichnet, daß der Ionen- und Elektronenbeschuß durch jeweils eine eigene, voneinander und vom Behandlungsverfahren unabhängige, den jeweiligen Bedingungen angepaßte Gleichstromquelle hervorgerufen wird, die abwechselnd mittels eines einstellbaren Pulsgerätes über ihren negativen bzw. positiven Pol mit dem Werkstückträger verbunden werden.

Die Verwendung zweier unabhängiger und nur für die Ionenreinigung bzw. Elektronenerwärmung ausgelegter Stromquellen hat den Vorteil, daß die Reinigungs- und Aufheizzeiten optimiert werden können und darüber hinaus eine stabile Prozeßführung möglich ist, da die Stromquellen nicht gleichzeitig zur Erzeugung des Plasmas verwendet werden.

Gemäß einer vorteilhaften Ausführungsform des erfindungsgemäßen Verfahrens wird zur Ionenreinigung der Werkstücke eine Hochspannungs-Gleichstromquelle mit einer Spannung von bis zu 1000 V und einer Stromstärke von bis zu 10 A verwendet. Zum Aufheizen der Werkstücke hingegen wird eine Hochstrom-Gleichstromquelle mit einer Stromstärke von bis zu 100 A und einer Spannung von bis zu 40 V verwendet.

Mit der unterschiedlichen Auslegung der Gleichstromquellen für die Ionenreinigung und die Elektronenaufheizung, nämlich einmal als Hochspannungsquelle und einmal als Hochstrom- bzw. Niederspannungsquelle, wird dem Umstand Rechnung getragen, daß beispielsweise zur Ionenreinigung ein Ionenstrom von nur wenigen Ampere bei einer hohen Spannung von bis zu 1000 V ausreichend ist, wohingegen zur Erzeugung einer ausreichenden Elektronenstromdichte zur Elektronenheizung eine Stromstärke von bis zu einigen 100 A bei einer nur geringen Spannung notwendig ist.

Zur Erreichung einer optimalen und energiesparenden Prozeßführung wird ein Pulsgerät verwendet, dessen einstellbare Schaltfrequenz bis zu 300 kHz beträgt. Das Verhältnis der Einschaltzeiten zwischen der Aufheizphase und der Ionenreinigungsphase kann dabei zwischen 0,1 und 0,9 liegen.

Als Pulsgerät mit der notwendig hohen Umschaltfrequenz wird vorteilhafterweise ein Halbleiter-Leistungs-Umschalter verwendet.

Weitere Einzelheiten sind aus den Ansprüchen zu entnehmen.

Weitere Einzelheiten und Vorteile ergeben sich aus der nachfolgenden Beschreibung der zugehörigen Zeichnungen, in denen ein schematischer Anlagenaufbau sowie zwei Diagramme dargestellt sind. In den Zeichnungen zeigen:
- Fig. 1: ein Spannungs-Strom-Kennliniendiagramm;
- Fig. 2: eine schematische Darstellung einer Plasmabeschichtungsanlage und
- Fig. 3: ein Spannungs-Strom-Zeit-Diagramm.

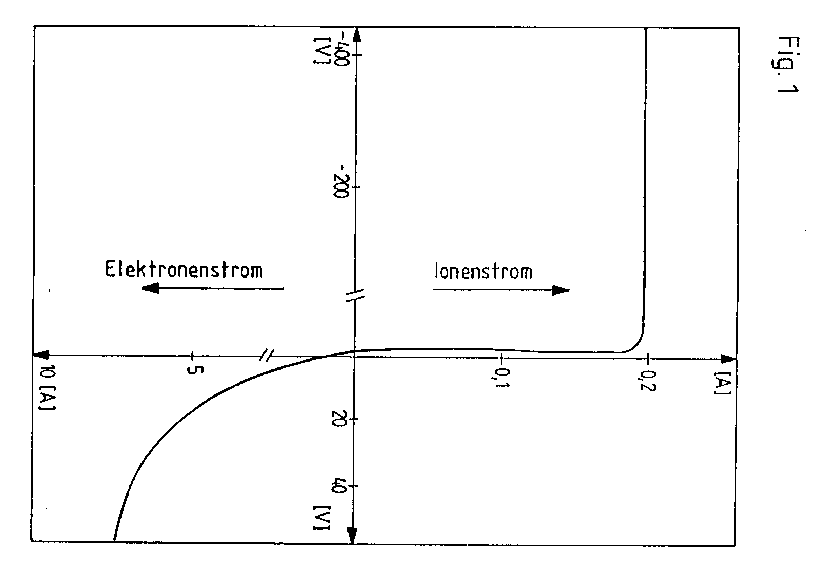

Wie aus dem in Fig. 1 dargestellten Spannungs-Strom-Kennliniendiagramm ersichtlich, sind für die Erzeugung ausreichender Elektronenstrom- bzw. Ionenstromdichten jeweils andere Stromstärken und Spannungen notwendig. So bedarf es beispielsweise für einen Elektronenstrom bei einer positiven Vorspannung von ca. 15 V einer Stromstärke von etwa 5 A, wohingegen für einen Ionenstrom bei einer negativen Vorspannung von 200 V nur ca. 0,2 A benötigt werden.

Um diesem unterschiedlichen Strom- bzw. Spannungsbedarf für den Ionen-und Elektronenfluß Rechnung zu tragen werden jeweils voneinander unabhängige, den jeweiligen Bedingungen angepaßte Gleichstromquellen verwendet, so daß eine optimal angepaßte und energiesparende Prozeßführung möglich wird. Diese Optimierung des Prozeßablaufes setzt jedoch voraus, daß die verwendeten unabhängigen und individuell ausgelegten Gleichstromquellen zusätzlich unabhängig von der Plasmaquelle betrieben werden.

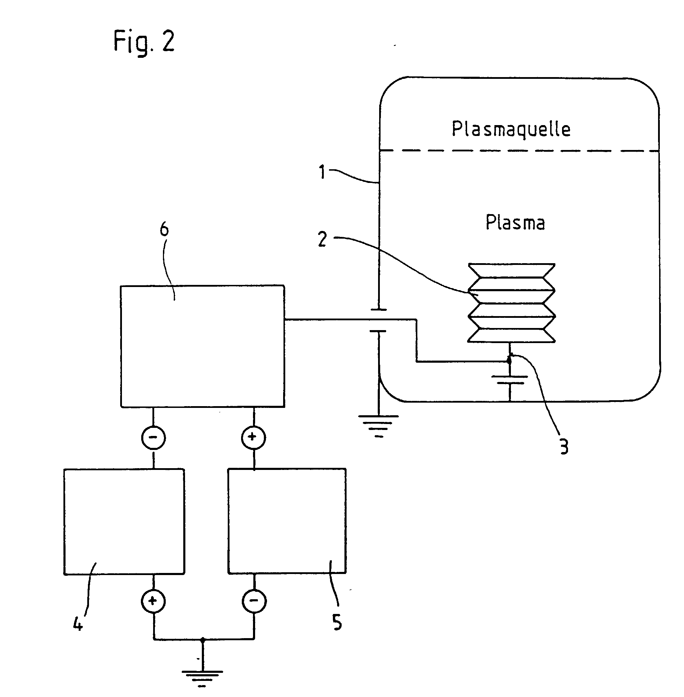

In Fig. 2 ist schematisch der Aufbau für eine Plasmabeschichtungsanlage dargestellt. Eine Plasmabeschichtungsanlage besteht aus einer Kammer 1, die mit Hilfe einer (nicht dargestellten) Pumpe evakuiert werden kann. In der Kammer 1 sind die zu behandelnden und zu beschichtenden Werkstücke 2 auf einem Werkstückträger 3 angeordnet.

Das für das Beschichtungsverfahren notwendige Plasma wird von einer ebenfalls in der Kammer 1 angeordneten Plasmaquelle (beispielsweise durch kathodische Vakuumbogenverdampfung) erzeugt.

Vor der Einleitung der eigentlichen Beschichtungsphase ist jedoch eine Reinigung der Oberflächen der Werkstücke 2, z. B. von Oxidhäuten, die sich an der Luft gebildet haben, sowie ein Aufheizen der Werkstücke 2 auf die Prozeßtemperatur von 200°C bis 500°C erforderlich. Zur Erzeugung des für die Reinigung und die Aufheizung der Oberflächen der Werkstücke 2 erforderlichen Ionen- und Elektronenbeschusses sind außerhalb der Kammer 1 eine Hochspannungs-Gleichstromquelle 4 sowie eine Hochstrom-Gleichstromquelle 5 angeordnet, die über ein zwischengeschaltetes Pulsgerät 6 mit dem Werkstückträger 3 verbunden sind. Das Pulsgerät 6 dient dabei der Optimierung der Prozeßbedingungen; da insbesondere zur Verringerung der Aufheizzeit eine abwechselnde Schaltung zwischen Ionenbeschuß und Elektronenbeschuß der Werkstücke 2 erforderlich ist.

Das Verfahren zur Plasmabehandlung von Werkstücken 2 mittels Ionen und Elektronen läuft wie folgt ab:

Das für den Beschichtungsprozeß notwendige Plasma wird von einer nicht dargestellten Plasmaquelle, beispielsweise mittels kathodischer Vakuumbogenverdampfung, hergestellt, wobei die zur Erzeugung des Plasmas notwendigen Verdampferkathoden über separate, ebenfalls nicht dargestellte Gleichstromquellen versorgt werden.

Die Werkstücke 2 werden vor der eigentlichen Plasmabeschichtung einer Vorbehandlung unterzogen, nämlich einer Reinigung der Oberflächen der Werkstücke sowie der Aufheizung auf die notwendige Beschichtungsprozeßtemperatur. Die Reinigung der Oberflächen der Werkstücke 2 erfolgt durch Beschuß der Werkstücke 2 mit aus dem Plasma gebildeten Ionen. Hierzu wird die Hochspannungs-Gleichstromquelle 4 über das Pulsgerät 6 mit ihrem negativen Pol mit dem Werkstückträger 3 verbunden. Infolge der bis zu 1000 V betragenden, von der Hochspannungs-Gleichstromquelle 4 erzeugten Spannung werden aufgrund der hohen Potentialdifferenz zwischen der Verdampferkathode der Plasmaquelle und dem mit dem negativen Pol der Hochspannungs-Gleichstromquelle 4 verbundenen Werkstückträger 3 die in dem Plasma gebildeten Ionen auf die auf dem Werkstückträger 3 angeordneten Werkstück 2 hin beschleunigt. Dieser Beschuß der Oberflächen der Werkstücke 2 mit den beschleunigten Ionen bewirkt ein Abtragen von Verunreinigungen, wie beispielsweise Oxidhäuten, die sich an der Luft gebildet haben. Darüber hinaus bewirkt der Ionenbeschuß bereits eine Erwärmung der Oberfläche. Der Ionenbeschuß der Werkstücke 2 darf aber auch nicht beliebig verlängert werden, da dies zu einer Schädigung der Oberflächen der Werkstücke 2 führen könnte. Somit ist es erforderlich, daß die Werkstücke 2 auf eine andere Weise aufgeheizt werden. Hierzu wird nun nach dem Abstellen der Hochspannungs-Gleichstromquelle 4 die Hochstrom-Gleichstromquelle 5 über ihren positiven Pol mit dem Werkstückträger 3 verbunden. Die eine Stromstärke von bis zu 100 A liefernde Hochstrom-Gleichstromquelle 5 bewirkt eine hohe Potentialdifferenz zwischen dem jetzt positiv gepolten Werkstückträger 3 und dem durch die Plasmaquelle erzeugten Plasma.

Aufgrund dieser Potentialdifferenz werden die in dem Plasma gebildeten Elektronen auf die auf dem Werkstückträger 3 angeordneten Werkstücke 2 hin beschleunigt. Die im Vergleich zu den Ionen geringere Masse der Elektronen bewirkt eine hohe Beschleunigung der Elektronen und somit eine hohe kinetische Energie der auf die Werkstücke 2 auftreffenden Elektronen, wodurch die Werkstücke 2 bei dem Elektronenbeschuß aufgeheizt werden.

Zur Optimierung der Prozeßbedingungen des voran geschilderten Verfahrens ist es notwendig, daß das abwechselnde Umschalten zwischen Ionenreinigung und Elektronenaufheizung innerhalb kürzester Zeit erfolgen kann. Zu diesem Zweck ist zwischen die Hochspannung-Gleichstromquelle 4 und die Hochstrom-Gleichstromquelle 5 das Pulsgerät 6 geschaltet, dessen Schaltfreqenz auf bis zu 300 kHz eingestellt werden kann.

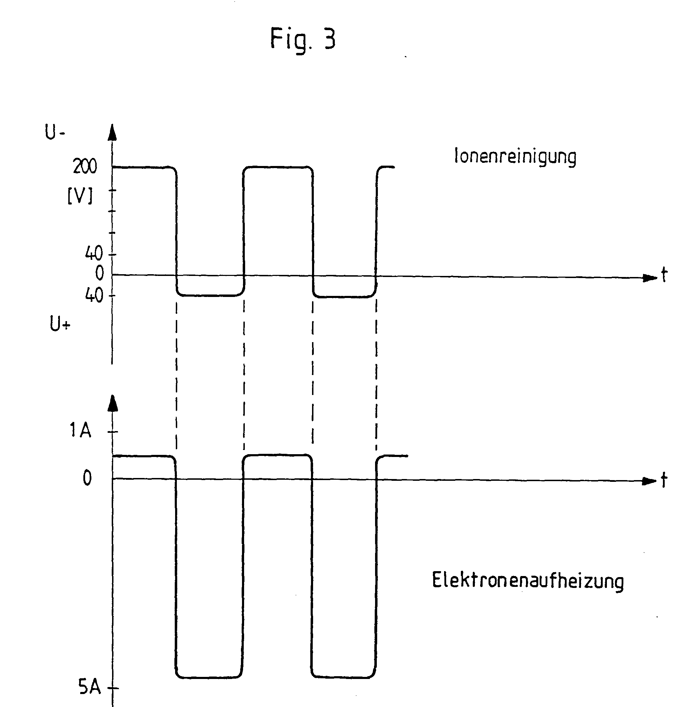

In Fig. 3 ist schematisch der zeitliche Spannungs- und Stromverlauf dargestellt, wie er sich infolge der abwechselnden Schaltung durch das Pulsgerät 6 ergibt. Durch die Verwendung eines Halbleiter-Leistungs-Umschalters als Pulsgerät 6 ist es möglich, daß das Umschalten zwischen der Ionenreinigungs- und Elektronenaufheizungsphase nahezu totzeitfrei erfolgen kann. Aufgrund der hohen Schaltfrequenz des Pulsgerätes 6 und infolge der individuellen Auslegung der Hochspannungs-Gleichstromquelle 4 und der Hochstrom-Gleichstromquelle 5 kann mit dem voranstehend geschilderten Verfahren die Prozeßführung optimiert und energiesparend betrieben werden.

### Bezugszeichenliste

- 1: Kammer
- 2: Werkstück
- 3: Werkstückträger
- 4: Hochspannungs-Gleichstromquelle
- 5: Hochstrom-Gleichstromquelle
- 6: Pulsgerät

## Patentansprüche

1. Verfahren zur Plasmabehandlung von Werkstücken mittels Ionen und Elektronen, insbesondere vor der Plasmabeschichtung unter Vakuum nach dem PVD-Verfahren, wobei durch abwechselnden Beschuß mit Ionen und Elektronen die Werkstücke (2) gereinigt bzw. aufgeheizt werden,
**dadurch gekennzeichnet,**
daß der Ionen- und Elektronenbeschuß durch jeweils eine eigene, voneinander und vom Beschichtungsverfahren unabhängige, den jeweiligen Bedingungen angepaßte Gleichstromquelle (4, 5) hervorgerufen wird, die abwechselnd mittels eines einstellbaren Pulsgerätes (6) mit ihrem negativen bzw. positiven Pol mit einem Werkstückträger (3) verbunden werden.

2. Verfahren nach Anspruch 1, dadurch gekennzeichnet, daß zur Ionenreinigung der Werkstücke (2) eine Hochspannungs-Gleichstromquelle (4) mit einer Spannung von bis zu 1000 V und einer Stromstärke von bis zu 40 A, vorzugsweise 10 A, verwendet wird.

3. Verfahren nach Anspruch 1, dadurch gekennzeichnet, daß zum Aufheizen der Werkstücke (2) eine Hochstrom-Gleichstromquelle (5) mit einer Stromstärke von bis zu 300 A, vorzugsweise 100 A, und einer Spannung von bis zu 100 V, vorzugsweise 40 V, verwendet wird.

4. Verfahren nach einem der Ansprüche 1 bis 3, dadurch gekennzeichnet, daß ein Pulsgerät mit einer Schaltfrequenz von bis zu 300 kHz, vorzugsweise 50 kHz, verwendet wird.

5. Verfahren nach einem der Ansprüche 1 bis 4, dadurch gekennzeichnet, daß das Verhältnis der Einschaltzeiten der Aufheizphase zu den Einschaltzeiten der Ionenreinigungsphase zwischen 0,1 und 0,9 liegt.

6. Verfahren nach einem der Ansprüche 1 bis 5, dadurch gekennzeichnet, daß als Pulsgerät (6) ein Halbleiter-Leistungs-Umschalter verwendet wird.

## Claims

1. Process for the plasma treatment of workpieces using ions and electrons, in particular before plasma deposition under vacuum using the PVD method, the workpiece (2) being cleaned and heated, respectively, by alternate bombardment with ions and electrons, characterized in that the ion bombardment and the electron bombardment are each carried out using their own DC source (4, 5), independent of each other and of the coating process and matched to the respective conditions, which are alternately connected to a workpiece carrier (3) using an adjustable pulse instrument (6) via its negative or positive pole, respectively.

2. Process according to Claim 1, characterized in that, for the ion cleaning of the workpieces (2), use is made of a high-voltage DC source (4) having a voltage of up to 1000 V and a current of up to 40 A, preferably 10 A.

3. Process according to Claim 1, characterized in that, for heating the workpieces (2), use is made of a heavy-current DC source (5) having a current of up to 300 A, preferably 100 A, and a voltage of up to 100 V, preferably 40 V.

4. Process according to one of Claims 1 to 3, characterized in that use is made of a pulse instrument having a switching frequency of up to 300 kHz, preferably 50 kHz.

5. Process according to one of Claims 1 to 4, characterized in that the ratio of the on times of the heating phase to the on times of the ion cleaning phase is between 0.1 and 0.9.

6. Process according to one of Claims 1 to 5, characterized in that a semiconductor power changeover switch is used as the pulse instrument (6).

## Revendications

1. Procédé destiné au traitement au plasma de pièces, au moyen d'ions et d'électrons, notamment avant le dépôt au plasma sous vide selon le procédé de dépôt physique en phase vapeur, et dans lequel les pièces (2) sont nettoyées ou bien chauffées par bombardement par ions et par électrons, à tour de rôle,
caractérisé en ce que
les bombardements ioniques et électroniques sont suscités chacun par une source de courant continu (4, 5) qui leur est propre, ces sources étant indépendantes l'une de l'autre ainsi que du procédé de dépôt et étant adaptées aux conditions correspondantes, tandis qu'elles sont reliées en alternance, par leur pôle négatif ou bien par leur pôle positif, à un porte pièce (3) au moyen d'un appareil générateur d'impulsions (6) réglable.

2. Procédé selon la revendication 1, caractérisé en ce que, pour le nettoyage ionique des pièces (2), on utilise une source de courant continu à haute tension (4), ayant une tension allant jusqu'à 1.000 V et une intensité allant jusqu'à 40 A, et de préférence de 10 A.

3. Procédé selon la revendication 1, caractérisé en ce que, pour le chauffage des pièces (2), on utilise une source de courant continu à haute intensité (5), ayant une intensité allant jusqu'à 300 A, de préférence de 100 A, et une tension allant jusqu'à 100 V, et de préférence de 40 V.

4. Procédé selon l'une des revendications 1 à 3, caractérisé en ce que l'on utilise un appareil générateur d'impulsions ayant une fréquence de commutation allant jusqu'à 300 kHz et, de préférence, de 50 kHz.

5. Procédé selon l'une des revendications 1 à 4, caractérisé en ce que le rapport des temps de fonctionnement de la phase de chauffage aux temps de fonctionnement de la phase de nettoyage ionique est compris entre 0,1 et 0,9.

6. Procédé selon l'une des revendications 1 à 5, caractérisé en ce que l'on utilise, en tant qu'appareil générateur d'impulsions (6), un commutateur de puissance à semi-conducteur.
